(19) Europäisches Patentamt
European Patent Office
Office européen des brevets

(11) EP 2 437 087 A1

(12) **EUROPEAN PATENT APPLICATION**

(43) Date of publication:
04.04.2012 Bulletin 2012/14

(51) Int Cl.:
*G02B 6/12* (2006.01)   *G02F 1/01* (2006.01)

(21) Application number: 10306052.1

(22) Date of filing: 29.09.2010

(84) Designated Contracting States:
AL AT BE BG CH CY CZ DE DK EE ES FI FR GB
GR HR HU IE IS IT LI LT LU LV MC MK MT NL NO
PL PT RO SE SI SK SM TR
Designated Extension States:
BA ME RS

(71) Applicant: Alcatel Lucent
75007 Paris (FR)

(72) Inventors:
• **Brenot, Romain**
  **91460, MARCOUSSIS (FR)**
• **De Valicourt, Guilhem**
  **91460, MARCOUSSIS (FR)**

(74) Representative: **Shamsaei Far, Hassan et al**
**Alcatel-Lucent International**
**32, avenue Kléber**
**92700 Colombes (FR)**

(54) **A tunable optical filter, an optical device integrating such filter and a method of filtering an optical signal**

(57) An optical filter adapted for being integrated within a structure of an optical device and a method of filtering an optical signal by means of the optical filter. A plurality of wavelength selective reflectors (45) are configured to reflect, in response to a selective switching action, a selected wavelength from a plurality of wavelengths received by the filter. In one embodiment current injection causes a tuning of Bragg gratings. In another embodiment a switched on semiconductor optical amplifier allows the passage at wavelengths to a corresponding Bragg grating.

FIG_4

EP 2 437 087 A1

**Description**

The present invention relates to optical components. The optical component may in particular be an optical receiver.

BACKGROUND ART

Currently used access networks are typically based on Time Division Multiplexing (TDM) of 1.25 Gbps or 2.5 Gbps, typically using a single wavelength for each traffic direction (up-link or down-link). A typical access network may be a passive Optical Network (PON) comprising a plurality of Optical Network Units (ONU) at or near users' premises. In order to meet an increasing demand of the market to provide PONs with higher capabilities of provision of services to end-users, service providers typically desire to upgrade the PONs. One trend towards upgrading the currently existing PONs is the provision of higher bitrates in such networks, typically up to or about 10 Gbps, typically with a single wavelength pair.

However, activities have recently started within FSAN (Full Service Access Networks) to define the next generation of PON, NGPON2. Briefly, FSAN is an organization with a mission of driving applicable standards, where they already exist, into services and products in the industry, and to develop new technical specifications for PONs.

Such tendencies may typically either lead to an increase of the bitrate, or to the use of several wavelengths for each kind of link (for example WDM/TDM-PON). Typically in access networks, the evolution of the PON strongly depends on the available technology. Increasing the number of wavelengths may be useful in order to improve the optical budget (for example by replacing power splitters by Arrayed Waveguide Gratings, *i.e.* AWGs), however a relatively high cost and often a limited availability of devices may still remain as limiting factors towards the interest for the use of such WDM/TDM-PONs. In particular, one drawback of such solutions is that each ONU typically should be receiving a single wavelength among a plurality of wavelengths transported on the network. If this wavelength is controlled by the network (for example using an AWG), the flexibility of the PON would be typically reduced.

SUMMARY

A known solution towards enabling the use of a single wavelength from among a plurality of wavelengths received is to implement tunable receivers at each ONU such that the receiver at a particular ONU is tuned so as to receive the wavelength which is intended for its use while other wavelengths are somehow discarded.

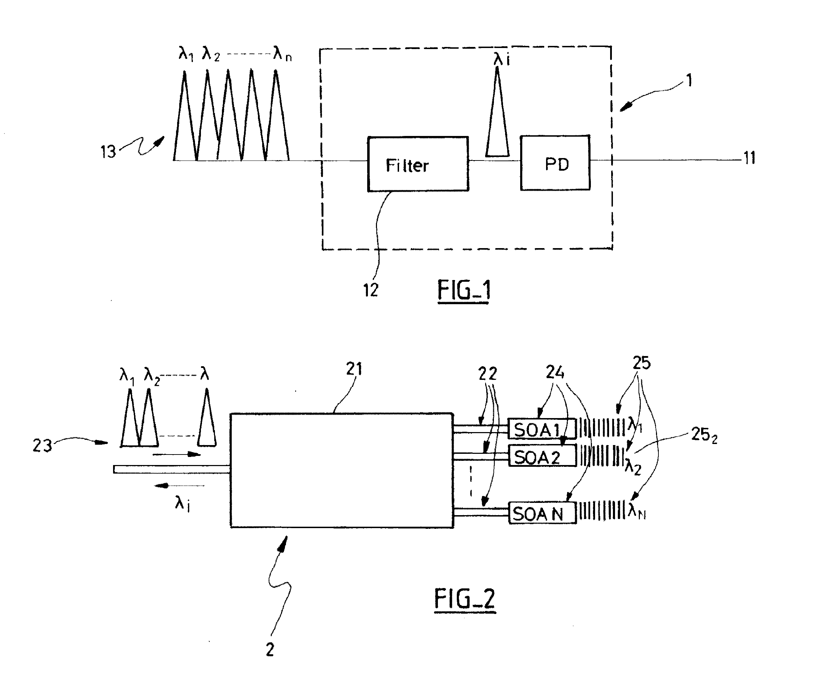

An example of a tunable receiver is shown in figure 1. As shown in the figure, the tunable receiver 1 comprises a receiving unit 11, which may typically be a photodetector (e.g. a photodiode) and a tunable filter 12. An optical signal 13 may arrive at the receiver 1 comprising a plurality of optical wavelengths $\lambda 1$, $\lambda 2, \dots, \lambda n$. Among the wavelengths arriving at the receiver 1, the photodiode 11 only detects the signal having the appropriate wavelength, $\lambda i$, corresponding to its operation which is allowed to pass to the photodiode by means of the tunable filter 12. This would require that the receiver 1 be able to decide which wavelength is to be detected and which wavelengths to be discarded so as to provide a satisfactory degree of flexibility.

Typically in an optical network cost is an issue. In particular in access networks, cost is typically the main issue or at least an important issue to take under consideration. This is especially significant at the ONU (which would comprise such receivers), where the costs are typically not shared with other users and thus has a direct impact on the cost of the ONU itself. Therefore, it is desirable to find solutions which contribute to reduce costs.

Integrating the tunable filter with the photo detector may be one desirable way to contribute to cost reduction.

Some embodiments of the present invention aim at providing an tunable optical filter which may be integrated with a photodetector within an optical device. Some embodiments aim at providing an optical device with an integrated tunable filter as featured herein.

Such device may be an optical receiver comprising a tunable optical filter and a photodetector integrated in the same device, preferably on a single chip. Tunable optical filters are known, one example of such know filters is a Wavelength Selective Switch (WSS).

However, at least some of such known WSSs suffer from drawbacks. One such drawback is due to the fact that these devices are typically based on free space optics and/or MEMs technology. They have intrinsic losses, typically 4 dB for WSS. Another drawback of such known WSSs is related to cost. These devices are typically developed for metropolitan networks where cost issues are not as critical as for access applications. Therefore, when a use is envisaged in an access network, the cost of these devices may become an important consideration.

An alternative solution may be to use a wavelength selector, typically based on the use of AWGs and Semiconductor Optical Amplifiers (SOAs). Such devices have been developed but, to the knowledge of the inventors, have not been commercialized because of cost issues, in particular fabrication costs. Furthermore, the size of such wavelength selectors is typically large, thereby making such devices less competitive for said intended use.

Some embodiments of the invention feature an optical filter adapted for being integrated within a structure of an optical device, the filter comprising a plurality of wavelength selective reflectors wherein the filter is configured to reflect, in response to a selective switching action, a selected wavelength from a plurality of wavelengths received by the filter.

According to some specific embodiments, the selective switching action is performed on a wavelength selective reflector form said plurality of wavelength selective reflectors so as to allow the reflection of said selected wavelength from said wavelength selective reflector in response to said selective switching action. According to some specific embodiments, the selective switching action is performed on a semiconductor optical amplifier form a plurality of semiconductor optical amplifiers, said semiconductor optical amplifier being configured to allow the passage of said selected wavelength to a respective wavelength selective reflector in response to said selective switching action.

According to some specific embodiments, the selective switching action is performed on an amplitude modulator form a plurality of amplitude modulators, said amplitude modulator being configured to allow the passage of said selected wavelength to a respective wavelength selective reflector in response to said selective switching action.

According to some specific embodiments, the optical filter comprises a plurality of coupled stripes, said coupled stripes being configured to couple an optical signal from one coupled stripe to another coupled stripe.

According to some specific embodiments, a coupled stripe comprises a waveguide wherein an output power of said waveguide depends on a dimension of the waveguide.

According to some specific embodiments said dimension is a length of the waveguide.

According to some specific embodiments, the wavelength selective reflectors are Bragg gratings.

Some embodiments of the invention feature an optical device comprising an optical filter as featured here in and a photodetector, the optical filter and the photodetector being integrated on a structure of the device.

Some embodiments of the invention feature an optical receiver comprising the optical device as featured herein.

According to some embodiments there is provided a method of filtering an optical signal by means of an optical filter, the optical filter being adapted to be integrated within a structure of an optical device, the method comprising:

- receiving a plurality of wavelengths,
- inputting said plurality of wavelengths to a plurality of wavelength selective reflectors,
- reflecting, in response to a selective switching operation performed on the filter, a selected wavelength of said plurality of wavelengths to an output of said filter.

According to some specific embodiments, the selective switching action is performed on a wavelength selective reflector form said plurality of wavelength selective reflectors thereby allowing the reflection of said selected wavelength. According to some specific embodiments, the selective switching action is performed on a semiconductor optical amplifier form a plurality of semiconductor optical amplifiers thereby allowing the passage of said selected wavelength to a respective wavelength selective reflector in response to said selective switching action.

According to some specific embodiments, the selective switching action is performed on an amplitude modulator form a plurality of amplitude modulators, said amplitude modulator thereby allowing the passage of said selected wavelength to a respective wavelength selective reflector in response to said selective switching action.

According to some specific embodiments, the optical filter comprises a plurality of coupled stripes and an optical signal is coupled from one coupled stripe to another coupled stripe.

These and further features and advantages of the present invention are described in more detail, for the purpose of illustration and not limitation, in the following description as well as in the claims with the aid of the accompanying drawings.

BRIEF DESCRIPTION OF THE DRAWINGS

Figure 1, already described, is an exemplary schematic representation of a tunable receiver.
Figure 2 is an exemplary schematic representation of a tunable optical filter according to an embodiment.
Figure 3 is an exemplary schematic representation of an optical receiver comprising a tunable optical filter according to the embodiment of figure 2.
Figure 4 is an exemplary schematic representation of a tunable optical filter according to an alternative embodiment.
Figure 5 is an exemplary schematic representation of a portion of the tunable optical filter of figure 4.

DETAILED DESCRIPTION

An example of a tunable optical filter 2 according to an embodiment of the invention is shown in figure 2. As shown in the figure, the tunable filter 2 comprises a multi-wavelength receiving unit 21 capable of receiving an optical signal 23 comprising a plurality of optical wavelengths $\lambda 1, \lambda 2,...,\lambda n$ and outputting said plurality of optical wavelengths $\lambda 1, \lambda 2,...,\lambda n$ from output branches, collectively shown in figure 2 by reference numeral 22. The multi-wavelength receiving unit 21 may be for a example a multi-mode interferometer (MMI). In each output branch 22 there is provided a semiconductor optical amplifier (SOA) capable of either amplifying or absorbing the optical signals. In the figure n semiconductor optical amplifiers are shown, SOA1 to SOAn. The amplifying of the optical signal may be performed by forward (direct) biasing of the SOA. This amplifying action is herein also referred to as a switching on operation. The absorption of the optical signals may be performed by a reverse (negative or grounded) biasing of the optical signal. The absorption action is herein also referred to as a switching off operation.

Downstream each SOA, there is provided a respective wavelength selective reflector collectively shown in figure 2 by reference numeral 25. Each wavelength selective reflector is preferably capable of reflecting only one of the incoming optical wavelengths $\lambda 1$, $\lambda 2,...,\lambda n$ .

The wavelength selective reflector may be for example a Bragg grating.

With the above arrangement, when a single SOA (say SOA2) is switched on, the other ones being switched off, only the switched on SOA (SOA2) allows the passage of the wavelengths $\lambda 1$, $\lambda 2,...,\lambda n$ to a corresponding wavelength selective reflector (say $25_2$). The wavelength selective reflector $25_2$ receiving the plurality of wavelengths is configured to only reflect one corresponding wavelength (say $\lambda 2$). As a consequence, the reflected wavelength $\lambda 2$ may be used as the wavelength for a specific operation and the rest of the wavelengths may thus be discarded, thereby performing the filtering operation.

Therefore, by switching on and off the SOAs, 24, it becomes possible to select the wavelength which is intended for a specific application (and discard the rest if desired).

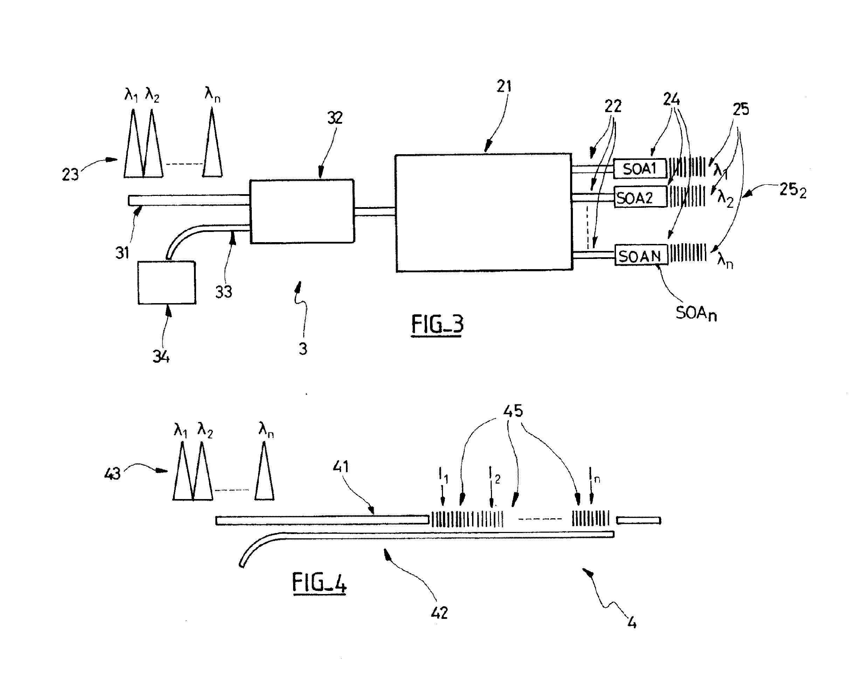

Figure 3 is an exemplary schematic representation of an optical receiver 3 using the tunable filter of figure 2. In this figure, like elements have been given like reference numerals as those of figure 2. The elements and the operation of the optical filter in figure 3 are similar to those of figure 2. However, as shown, the optical signal 23, comprising a plurality of optical wavelengths $\lambda 1$, $\lambda 2,...,\lambda n$ is input at an input port 31 of a coupler 32. Examples of couplers for this purpose may be a multimode interferometer, coupled stripes and Y-junctions among others.

The coupler 32 is configured to direct the plurality of the optical wavelengths $\lambda 1$, $\lambda 2,...,\lambda n$ , to the multiwavelength receiving unit 21. The coupler 32 is also configured to receive a wavelength (say $\lambda 2$), reflected back from the optical filter as described above in relation to figure 2 and provide said reflected wavelength $\lambda 2$ at an output 33 thereof. The optical receiver further comprises a photodetector 34, such as for example a photodiode, coupled to said output port 33 of the coupler 32.

Therefore, in operation, the wavelength $\lambda 2$ , selected as the wavelength to be detected, after a reflection by the optical filter as described above in relation to figure 2, is directed to the photodetector 34 which is in charge of receiving and detecting said wavelength for a desired application.

Those skilled in the related art will realize that a device as described in relation to figure 3 (in conjunction to figure 2) may be integrated on a single chip, either monothically on InP substrate (similarly to Photonic Integrated Circuits), or on Si platform.

It is to be noted that the SOAs may be replaced by amplitude modulators (such as Mach-Zehnder or electro-absorption modulators). Such modulators are typically passive devices, which may be preferable certain application whereas SOAs may be preferred in other applications so as to provide gain which may be used to compensate for the filter losses. The principles of operation of a tunable optical filter comprising such amplitude modulators is similar to those of a filter using SOAs as already described in relation to figure 2. Therefore a detailed description of such operation is considered not necessary.

An exemplary representation of an alternative embodiment of an optical filter capable of being integrated in an optical device is shown in figure 4.

In this configuration, advantage is taken of the fact that the wavelength selective reflectors (such as for example Bragg gratings) themselves may be tuned.

By injecting current into the Bragg grating, the Bragg wavelength may be shifted to other frequencies. This effect is due to the change of the refractive index due to a variation of the carrier density.

Such capacity in a DBR may reach wavelengths of about 16 nm with an optical confinement of 80%. By injecting current into a Bragg grating of a DBR, it is possible to generate a wavelength shift.

The optical filter 4 of figure 4 comprises a plurality of coupled stripes 41, 42. Coupled stripes are optical waveguides with predetermined dimensions and preferably a precise separation between the two stripes. The length of the coupled region between the two waveguides depends on the waveguides width and the separation between both waveguides,

One characteristic of coupled stripes is the ability of coupling an optical mode from one coupled stripe to another along a propagation path in the region coupled between two coupled stripes. Such characteristic is known to those skilled in the related art. For example reference may be made to "Marcuse Theory of dielectric optical waveguide New York, Academic Press, Inc., 1974. p. 267" which is incorporated by reference herein in its entirety. Preferably two stripes are used.

The optical filter further comprises a plurality of wavelength selective reflectors collectively shown in the figure by reference numeral 45 and individually by reference numerals l1, l2,...ln. The wavelength selective reflectors may be for example Bragg gratings.

An optical signal 43 comprising a plurality of optical wavelengths $\lambda 1$, $\lambda 2,...,\lambda n$ may be input in the optical filter 4 through the coupled stripe 41. The optical wavelengths $\lambda 1$, $\lambda 2,...,\lambda n$ travel downstream (from left to right in figure 4) an optical waveguide comprised in the coupled stripe 41 and reach the wavelength selective reflectors 45. Each of the wavelength selective reflectors 11, 12,...In, is preferably configured to reflect a corresponding optical wavelength λ1, λ2,...,λn .

The tunability of the wavelength selective reflectors I1, I2,...In, allows for selecting the wavelength desired for a specific application. Such tenability allows for switching on a wavelength selective reflector and switching off the rest of the wavelength selective reflectors. The wavelength selective reflector which is switched on is therefore capable of reflecting back a selected wavelength (the wavelength that corresponds to its reflectivity capability), whereas other wavelength selective reflector which are turned off do not reflect the rest of the wavelengths, the latter being discarded if desired.

After being reflected from the respective wavelength selective reflector, say I2, the selected wavelength, say λ2 , travels back toward the coupled stripe 41 (from right to left in figure 4) and is coupled from the coupled stripe 41 to the adjacent coupled stripe 42 through which it is guided to an output port of the coupled stripe 42, preferably to a photodetector (not shown).

Therefore, by switching on and off the integrated wavelength selective reflectors, one can select the received wavelength.

In case, the optical filter is designed for coupling all, or a plurality, of the optical wavelengths to the output coupled stripe 42 so as to guide them to a photodetector, then all, or a corresponding plurality, of the wavelength selective reflectors, I1 to In, are switched on. Switching on the current causes a tuning of the Bragg grating to the desired wavelength. Likewise, when only one wavelength selective reflector, say I2, is switched on, the corresponding optical wavelength λ2 (i.e. the wavelength that the wavelength selective reflector I2 is configured to reflect) is selected in order to be detected by the photodetector.

In selecting such wavelength, the design characteristics of the coupled stripes may be taken into account. In fact, the coupling between the two stripes depends on the wavelength. The width and the separation between both waveguides need to be fixed accordingly and the Bragg grating are positioned depending on the wavelength they should reflect.

For a specific (selected) optical wavelength, the coupled stripes are preferably designed properly with a corresponding length, determined as precise as possible, in order to ensure an optimized output power for the selected optical wavelength at the output of the coupled stripe (42 in figure 4) which guides the selected wavelength to the photodetector. The determination of the length depends on the wavelength therefore each wavelength selective reflector is preferably placed in a different position as compared to the others, thereby providing different lengths on the coupled stripes corresponding to different wavelengths.

Therefore, coupled stripes may be carefully designed to select a given optical wavelength based on the geometrical shape and length of the coupled waveguides as well as the position of the wavelength selective reflectors. The following is an exemplary explanation of the relationship between the wavelengths and the dimensions, assuming waveguides a and b are considered: The amplitudes a(z) and b(z) satisfy the following relationship:

$$a(z) = \cos Kze^{i\beta z}$$
$$b(z) = \sin Kze^{i\beta z}$$

Where K is the coupling coefficient and β the propagation constant.

The propagation constant depends on the wavelength and the coupling coefficient on the waveguides dimensions.

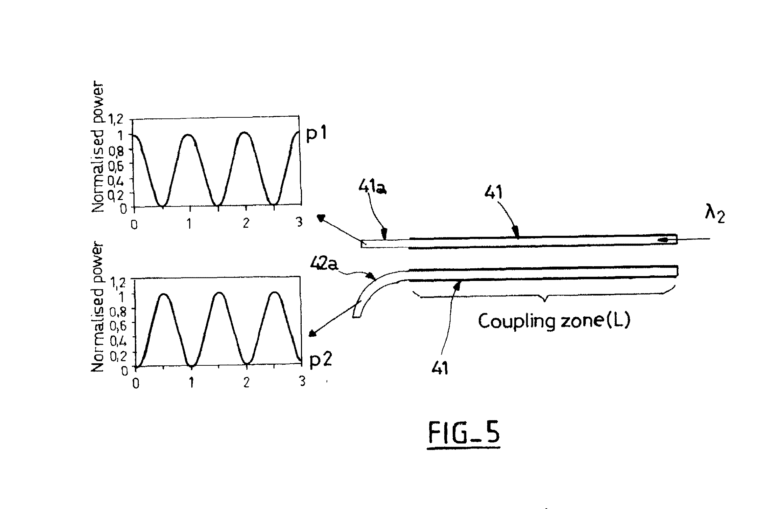

Figure 5 is an exemplary schematic representation of a portion of the tunable optical filter of figure 4. This figure schematically illustrates a length L determined for coupling a specific wavelength between the coupled stripes 41 and 42. Figure 5 further schematically illustrates an output power $P_1$ corresponding the wavelength selected to be reflected by a wavelength selective reflector and output from an output port 41 a of the coupled stripe 41, and an output power $P_2$ corresponding the same wavelength selected to be reflected by said wavelength selective reflector, coupled from coupled stripe 41 into coupled stripe 42, and output from an output port 42a of the coupled stripe 42 (which as discussed in relation to the embodiment of figure 4 is then input into a photodetector). As shown in figure 5, the output powers $P_1$ and $P_2$ from the two output ports 41 a and 42a are in anti-phase as shown in the graphs corresponding to $P_1$ and $P_2$ in figure 5. Typically said output powers vary as $\sin^2$ and $\cos^2$ functions of the length of the coupling zone and the coupling factor |k| according to the following formulae. The anti-phase arrangement helps to avoid a reflection back to the first stripe, 41.

$$P_1 = Pin \cos^2(|k|L), \text{ and}$$
$$P_2 = Pin \cos^2(|k|L)$$

Where $P_{in}$ is the input power of the optical signal.

The graphs corresponding to $P_1$ and $P_2$ schematically show normalized output power as a function of the product .$\cos^2(|k|L)/k$.

The devices proposed in this embodiment are passive which is a desirable feature for low energy consumption and typically requires simple processing.

The solution proposed in the various embodiments described herein can be integrated easily with other devices on a single chip. This can be done on InP or Silicon platform where coupled waveguide technology is already mature. The optical filter as proposed herein can be used for a large range of wavelengths, therefore contributing to the reduction of deployment costs.

In order to reduce possible crosstalk, the wavelength selective reflectors may be apodized (which is a known technique)

Therefore, the solution provided herein can lead to cost-effective wavelength selective receivers.

The various embodiments described herein require simple processes which make the resulting product cost effective.

The various embodiments of the present invention may be combined as long as such combination is compatible and/or complimentary.

Further it is to be noted that the list of structures corresponding to the claimed means is not exhaustive and that one skilled in the art understands that equivalent structures can be substituted for the recited structure without departing from the scope of the invention.

It should be appreciated by those skilled in the art that any block diagrams herein represent conceptual views of illustrative circuitry embodying the principles of the invention.

## Claims

1. An optical filter adapted for being integrated within a structure of an optical device, the filter comprising a plurality of wavelength selective reflectors wherein the filter is configured to reflect, in response to a selective switching action, a selected wavelength from a plurality of wavelengths received by the filter.

2. The optical filter of claim 1 wherein the selective switching action is performed on a wavelength selective reflector form said plurality of wavelength selective reflectors so as to allow the reflection of said selected wavelength from said wavelength selective reflector in response to said selective switching action.

3. The optical filter of claim 1 wherein the selective switching action is performed on a semiconductor optical amplifier form a plurality of semiconductor optical amplifiers, said semiconductor optical amplifier being configured to allow the passage of said selected wavelength to a respective wavelength selective reflector in response to said selective switching action.

4. The optical filter of claim 1 wherein the selective switching action is performed on an amplitude modulator form a plurality of amplitude modulators, said amplitude modulator being configured to allow the passage of said selected wavelength to a respective wavelength selective reflector in response to said selective switching action.

5. The optical filter of any one of claims 1 to 2 wherein the optical filter comprises a plurality of coupled stripes, said coupled stripes being configured to couple an optical signal from one coupled stripe to another coupled stripe.

6. The optical filter of claim 5 wherein a coupled stripe comprises a waveguide wherein an output power of said waveguide depends on a dimension of the waveguide.

7. The optical filter of claim 6 wherein said dimension is a length of the waveguide.

8. The optical filter of any one of the previous claims wherein the wavelength selective reflectors are Bragg gratings.

9. An optical device comprising an optical filter according to any one of the claims 1 to 8 and a photodetector, the optical filter and the photodetector being integrated on a structure of the device.

10. An optical receiver comprising the optical device of claim 9.

11. A method of filtering an optical signal by means of an optical filter, the optical filter being integrated within a structure of an optical device, the method comprising:

   - receiving a plurality of wavelengths,
   - inputting said plurality of wavelengths to a plurality of wavelength selective reflectors,
   - reflecting, in response to a selective switching operation performed on the filter, a selected wavelength of said plurality of wavelengths to an output of said filter.

12. The method of claim 11 wherein the selective switching action is performed on a wavelength selective reflector form said plurality of wavelength selective reflectors thereby allowing the reflection of said selected wavelength.

13. The method of claim 11 wherein the selective switching action is performed on a semiconductor optical amplifier form a plurality of semiconductor optical amplifiers thereby allowing the passage of said selected wavelength to a respective wavelength selective reflector in response to said selective switching action.

14. The method of claim 11 wherein the selective switching action is performed on an amplitude modulator form a plurality of amplitude modulators, said amplitude modulator thereby allowing the passage of said selected wavelength to a respective wavelength selective reflector in response to said selective switching action.

15. The method of claim 11 or claim 12 wherein the optical filter comprises a plurality of coupled stripes and an optical signal is coupled from one coupled stripe to another coupled stripe.

EP 2 437 087 A1

λ₁ λ₂ ------ λₙ

λᵢ

13

Filter

PD

11

1

12

FIG_1

λ₁ λ₂ ------ λ

21

22

24

25

23

SOA1

λ₁

SOA2

λ₂

25₂

λᵢ

SOA N

λ_N

2

FIG_2

EP 2 437 087 A1

$\lambda_1$ $\lambda_2$ $\lambda_n$

23

31

34

33

32

3

21

22

24

25

SOA1 $\lambda_1$

SOA2 $\lambda_2$ $25_2$

SOAN $\lambda_n$

SOAn

FIG_3

$\lambda_1$ $\lambda_2$ $\lambda_n$

43

41

45

$I_1$ $I_2$ $I_n$

42

4

FIG_4

FIG_5

Europäisches
Patentamt

European
Patent Office

Office européen
des brevets

# EUROPEAN SEARCH REPORT

Application Number

EP 10 30 6052

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 5 416 866 A (SAHLEN OLOF G [SE]) 16 May 1995 (1995-05-16) * column 3, line 68 - column 4; figure 1 * * column 6, lines 40-62; figure 5 * | 1,2, 5-12,15 | INV. G02B6/12 G02F1/01 |
| X | WO 2005/047963 A1 (HOYA CORP [JP]; GUNTHER JOHN EDWARD [US]) 26 May 2005 (2005-05-26) * page 8, line 1 - page 9, line 11 * | 1,2, 5-12,15 | |
| X A | WO 03/102659 A2 (INFINERA CORP [US]) 11 December 2003 (2003-12-11) * page 15, line 22 - page 16, line 4; figure 68 * * page 27; figure 19 * | 1,2,8-10 3,13 | |
| X | JEAN-PIERRE WEBER ET AL: "An Integratable Polarization-Independent Tunable Filter for WDM Systems: The Multigrating Filter", JOURNAL OF LIGHTWAVE TECHNOLOGY, IEEE SERVICE CENTER, NEW YORK, NY, US, vol. 14, no. 12, 1 December 1996 (1996-12-01), XP011028732, ISSN: 0733-8724 * page 2720; figure 2 * * figures 11-13 * | 1,2,8, 11,12 | TECHNICAL FIELDS SEARCHED (IPC) G02B G02F H01S |
| X | GB 2 360 890 A (ILOTRON LTD [GB]) 3 October 2001 (2001-10-03) * page 2, line 36 - page 3, line 30; figure 1 * | 1,3,8, 11,13 | |
| X | US 5 016 960 A (EICHEN ELLIOT [US] ET AL) 21 May 1991 (1991-05-21) * column 4, lines 17-20; claims 5-7 * | 1,3,8, 11,13 | |
| X A | JP 2000 077756 A (NEC CORP) 14 March 2000 (2000-03-14) * abstract * * paragraph [0032] * | 1,3,8 13 | |

The present search report has been drawn up for all claims

| Place of search | Date of completion of the search | Examiner |
|---|---|---|
| Berlin | 14 June 2011 | Ciarrocca, Marco |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

Application Number

EP 10 30 6052

## CLAIMS INCURRING FEES

The present European patent application comprised at the time of filing claims for which payment was due.

☐ Only part of the claims have been paid within the prescribed time limit. The present European search report has been drawn up for those claims for which no payment was due and for those claims for which claims fees have been paid, namely claim(s):

☐ No claims fees have been paid within the prescribed time limit. The present European search report has been drawn up for those claims for which no payment was due.

## LACK OF UNITY OF INVENTION

The Search Division considers that the present European patent application does not comply with the requirements of unity of invention and relates to several inventions or groups of inventions, namely:

see sheet B

☐ All further search fees have been paid within the fixed time limit. The present European search report has been drawn up for all claims.

☐ As all searchable claims could be searched without effort justifying an additional fee, the Search Division did not invite payment of any additional fee.

☒ Only part of the further search fees have been paid within the fixed time limit. The present European search report has been drawn up for those parts of the European patent application which relate to the inventions in respect of which search fees have been paid, namely claims:

1-3, 5-13, 15

☐ None of the further search fees have been paid within the fixed time limit. The present European search report has been drawn up for those parts of the European patent application which relate to the invention first mentioned in the claims, namely claims:

☐ The present supplementary European search report has been drawn up for those parts of the European patent application which relate to the invention first mentioned in the claims (Rule 164 (1) EPC).

Europäisches
Patentamt

European
Patent Office

Office européen
des brevets

**LACK OF UNITY OF INVENTION
SHEET B**

Application Number

EP 10 30 6052

The Search Division considers that the present European patent application does not comply with the
requirements of unity of invention and relates to several inventions or groups of inventions, namely:

    1. claims: 2, 5-7, 12, 15(completely); 1, 8-11(partially)

        Optical filter with coupled stripes and selective switching
        action on wavelength selective reflectors
                        ---

    2. claims: 3, 13(completely); 1, 8-11(partially)

        optical filter with semiconductor optical amplifier for
        wavelength selection
                        ---

    3. claims: 4, 14(completely); 1, 8-11(partially)

        optical filter with amplitude modulator for wavelength
        selection
                        ---

## ANNEX TO THE EUROPEAN SEARCH REPORT
## ON EUROPEAN PATENT APPLICATION NO.

EP 10 30 6052

This annex lists the patent family members relating to the patent documents cited in the above-mentioned European search report.
The members are as contained in the European Patent Office EDP file on
The European Patent Office is in no way liable for these particulars which are merely given for the purpose of information.

14-06-2011

| Patent document cited in search report | | Publication date | Patent family member(s) | | Publication date |
|---|---|---|---|---|---|
| US 5416866 | A | 16-05-1995 | DE 4328777 A1 | | 17-03-1994 |
| | | | FR 2695212 A1 | | 04-03-1994 |
| | | | GB 2270174 A | | 02-03-1994 |
| | | | JP 6194613 A | | 15-07-1994 |
| | | | SE 470454 B | | 11-04-1994 |
| | | | SE 9202446 A | | 27-02-1994 |
| WO 2005047963 | A1 | 26-05-2005 | NONE | | |
| WO 03102659 | A2 | 11-12-2003 | AU 2002367907 A1 | | 19-12-2003 |
| | | | CA 2463545 A1 | | 11-12-2003 |
| | | | EP 1488265 A2 | | 22-12-2004 |
| GB 2360890 | A | 03-10-2001 | NONE | | |
| US 5016960 | A | 21-05-1991 | NONE | | |
| JP 2000077756 | A | 14-03-2000 | JP 3529275 B2 | | 24-05-2004 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Marcuse Theory of dielectric optical waveguide New York. Academic Press, Inc, 1974, 267